# EUROPÄISCHE PATENTSCHRIFT

(11) **EP 1 440 282 B1**
(45) Veröffentlichungstag und Bekanntmachung des Hinweises auf die Patenterteilung: **21.12.2005**
(21) Anmeldenummer: 02777088.2
(22) Anmeldetag: 13.09.2002
(51) Int. Cl.: F25D 19/00, H05K 7/20

(54) **KÜHLGERÄT MIT KÄLTEMITTEL-KREISLAUF**
REFRIGERATING APPLIANCE COMPRISING A REFRIGERANT CIRCUIT
APPAREIL REFRIGERANT AVEC CIRCUIT D'AGENT REFRIGERANT

(30) Priorität: 23.10.2001 DE 10152239
(43) Veröffentlichungstag der Anmeldung: 28.07.2004
(73) Patentinhaber: Rittal GmbH & Co. KG, 35745 Herborn (DE)
(72) Erfinder: MAUL, Joachim, 35630 Ehringshausen (DE)
(74) Vertreter: Fleck, Hermann-Joseph
(86) Internationale Anmeldenummer: PCT/EP2002/010283
(87) Internationale Veröffentlichungsnummer: WO 2003/036206

(56) Entgegenhaltungen:
- WO-A-91/06995
- DE-A- 3 002 261
- DE-A- 10 007 467
- DE-A- 19 531 310
- DE-C- 481 667
- GB-A- 814 252
- US-A- 2 391 507
- US-A- 2 669 853
- US-A- 5 504 924

## Beschreibung

Die Erfindung betrifft ein Kühlgerät mit einem in einem Gerätegehäuse untergebrachten Kältemittel-Kreislauf mit Kompressor, Verdampfer und Verflüssiger, wobei der Kältemittel-Kreislauf einen Innenkreis und einen Außenkreis aufweist, wobei der Innenkreis über eine Seitenwand des Gerätegehäuses über eine Lufteintrittsöffnung und eine Luftaustrittsöffnung mit einem zu kühlenden Raum, vorzugsweise einem Schaltschrankinnenraum, in Verbindung steht und dem Innenkreis der Verdampfer und dem Außenkreis der Verflüssiger des Kältemittelkreislaufes zugeordnet sind.

Derartige Kühlgeräte, die vorzugsweise auf einem Schaltschrankgehäuse aufgebaut oder an einer Seitenwand des Schaltschrankgehäuses angebaut werden, sind in verschiedenen Konstruktionen und Ausbauten und damit unterschiedlichen Kühlleistungen bekannt. Dabei ist in der Regel dem Verflüssiger ein Ventilator zur Kühlung beigeordnet, der Frischluft aus der Umgebung des Kühlgeräte-Gehäuses ansaugt und in den Kühlgeräte-Innenraum fördert. Dieser Aufbau hat den Nachteil, dass das Kühlgeräte-Gerätegehäuse trotz dichtem Auf-oder Anbau am Schaltschrankgehäuse nicht dicht abgeschlossen und nicht in einer Schutzart IP 55 oder größer ausgelegt werden kann. Dies ist besonders von Nachteil, wenn der Schaltschrank mit dem Kühlgerät der Atmosphäre ausgesetzt werden.

Es sind Wärmetauscher bekannt, bei denen Flüssigkeit und Luft als Wärmetauscher-Medien verwendet werden. Dabei stellt der Wärmetauscher einen plattenförmigen Grundkörper mit Flüssigkeitsleistungen dar, der mit Kühlrippen versehen ist und als Träger für wärmeabführende elektrische Schaltkreise verwendet wird, wie die EP 0 747 953 A2 zeigt.

Aus der DE-A-100 07 467 ist ein Kühlgerät bekannt, das einen als Grundplatte mit eingebetteten Kühlmittelleitungen ausgebildeten Verflüssiger aufweist, wobei die Grundplatte angeformte, an deren Außenseite abstehende Kühlrippen aufweist.

Es ist Aufgabe der Erfindung, ein Kühlgerät der eingangs erwähnten Art so zu gestalten, dass das Gerätegehäuse bis auf die Lufteintrittsöffnung und die Luftaustrittsöffnung vollständig verschlossen und in einer Schutzart IP 55 oder größer ausgelegt werden kann.

Diese Aufgabe wird nach der Erfindung dadurch gelöst, dass alle Seitenwände bis auf die Seitenwand mit der Lufteintrittsöffnung und der Luftaustrittsöffnung des Gerätegehäuses vollständig geschlossen sind, dass der Verflüssiger als Grundplatte mit eingebetteten Kühlmittelleitungen ausgebildet ist, die zumindest einen Teil einer Seitenwand des Gerätegehäuses bildet und angeformte , an deren Außenseite abstehende Kühlrippen aufweist.

Bei dieser Ausgestaltung kann der normalerweise dem Außenkreis mit dem Verflüssiger zugeordnete Ventilator entfallen. Eine luftleitende Verbindung vom Kühlgeräte-Innenraum zur Umgebung ist nicht mehr erforderlich, da der so gestaltete Verflüssiger absolut dicht in das Gerätegehäuse eingebaut werden kann und die über die Kühlmittel zugeführte Wärme über die in der Umgebungsluft angeordneten Kühlrippen abgeführt werden kann. Es steht am Gerätegehäuse genügend Fläche an Seitenwänden zur Verfügung, um mit dieser Art von Verflüssiger eine ausreichende Kühlleistung zu erreichen. Das Klimagerät kann dicht an einen Schaltschrank angekoppelt werden, wobei die freiliegenden Gehäuse-Seitenwände hermetisch abgeschlossen sind und eine Schutzart nach IP 55 oder größer erreicht werden kann.

Die Ankopplung des Kühlgerätes an den Schaltschrank erfolgt vorzugsweise in der Weise, dass die Seitenwand mit der Lufteintrittsöffnung und der Luftaustrittsöffnung mittels Dichtungselementen mit dem zu kühlenden Raum, insbesondere dem den Schaltschrankinnenraum umschließenden Schaltschrankgehäuse verbunden ist, wobei die Lufteintrittsöffnung des Kühlgerätes mit der Luftaustrittsöffnung des Schaltschrankgehäuses und die Luftaustrittsöffnung des Kühlgerätes mit der Lufteintrittsöffnung des Schaftschränkgehäuses fluchten.

Der Wärmeübergang vom Kühlmittel auf die Grundplatte des Verflüssigers wird dadurch verbessert, dass die Kühlmittelleitungen als Kühlschlange in der Grund-platte des Verflüssigers eingebettet sind.

Für einen einfachen Aufbau des Verflüssigers ist vorgesehen, dass die Kühlmittelleitungen in Aufnahmenuten der Grundplatte des Verflüssigers eingebettet sind, die in der dem Kühlgerät-Innenraum zugekehrten Oberfläche der Grund-platte eingebracht sind. Dabei kann die Zu- und Ableitung des Kühlmittels so erfolgen, dass die Kühlmittelleitungen im Bereich des oberen Teils der Grundplatte eingeführt und im Bereich des unteren Teils der Grundplatte herausgeführt ist.

Ist nach einer Weiterbildung vorgesehen, dass den Kühlrippen des Verflüssigers ein Außen-Ventilator und im Kühlgerät dem Verdampfer ein Innen-Ventilator zugeordnet sind, dann kann ohne Beeinträchtigung der Schutzart des Kühlgerätes die Kühlleistung gesteigert werden.

Der Aufbau des Kühlmittel-Kreislaufes mit Druckwächter, Filter- und Trockeneinrichtung und Entspannungsventil kann in bekannter Weise beibehalten werden.

Als Aufbau mit guter Kühlleistung hat sich eine Materialwahl als besonders geeignet erwiesen, die dadurch gekennzeichnet ist, dass die Grundplatte mit den angeformten Kühlrippen aus Aluminium besteht und dass die Kühlmittelleitungen Kupferrohre sind. Auch andere Materialien sind verwendbar, z.B. Grundplatine aus Kupfer oder Edelstahl mit anderer Wärmeübertragungscharakteristik.

Die Erfindung wird anhand eines in den Zeichnungen dargestellten Ausführungsbeispiels näher erlätert. Es zeigen:
- Fig. 1: in perspektivischer Ansicht ein auf einem Schaltschrankgehäuse aufgebautes Kühlgerät und
- Fig. 2: einen schematischen Aufbau des Kühlgerätes.

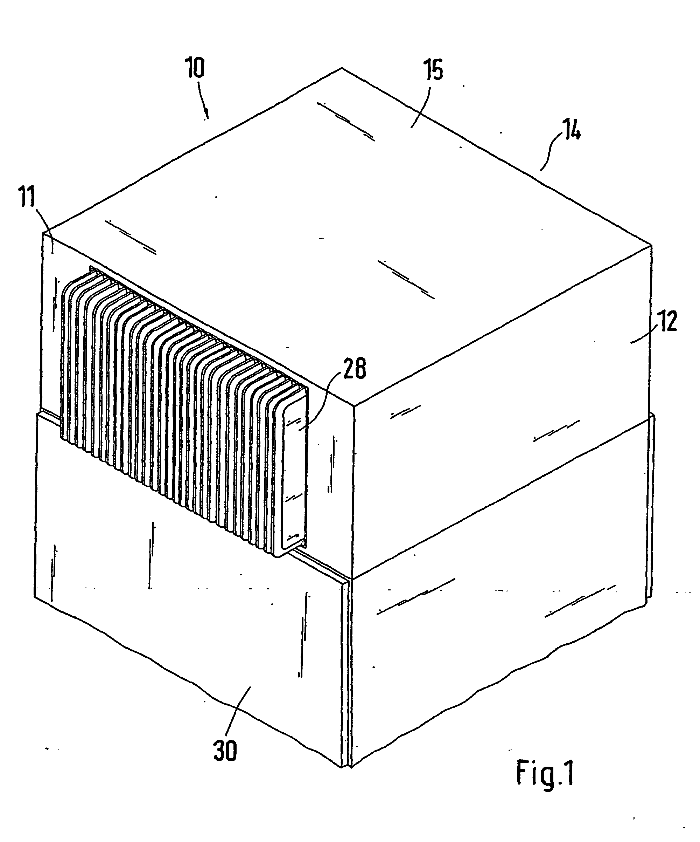

Wie die Ansicht nach Fig. 1 zeigt, kann ein Kühlgerät mit dem geschlossenen Gerätegehäuse 10 mit der nicht einsehbaren Bodenwand 16 mit der Deckwand des Schaltschrankgehäuses 30 dicht verbunden werden, wobei an sich bekannte Dichtungselemente auch eine elektrische Verbindung der beiden Gehäuse herstellen können. Der Übergang ist leicht so zu gestalten, dass er der Schutzart IP 55 oder größer genügt. Die übrigen Seitenwände 11, 12, 13, 14 und 15 des Gerätegehäuses 10 erfüllen diese Voraussetzungen ebenfalls, da an keiner Stelle eine luftleitende Verbindung von der Umgebung in den Kühlgeräte-Innenraum erforderlich ist. An der Seitenwand 11 stehen lediglich Kühlrippen 28 eines noch näher zu erläuternden Verflüssigers 26 des Kühlmittel-Kreislaufes ab, der jedoch absolut hermetisch abgeschlossen in die Seitenwand 11 integriert ist.

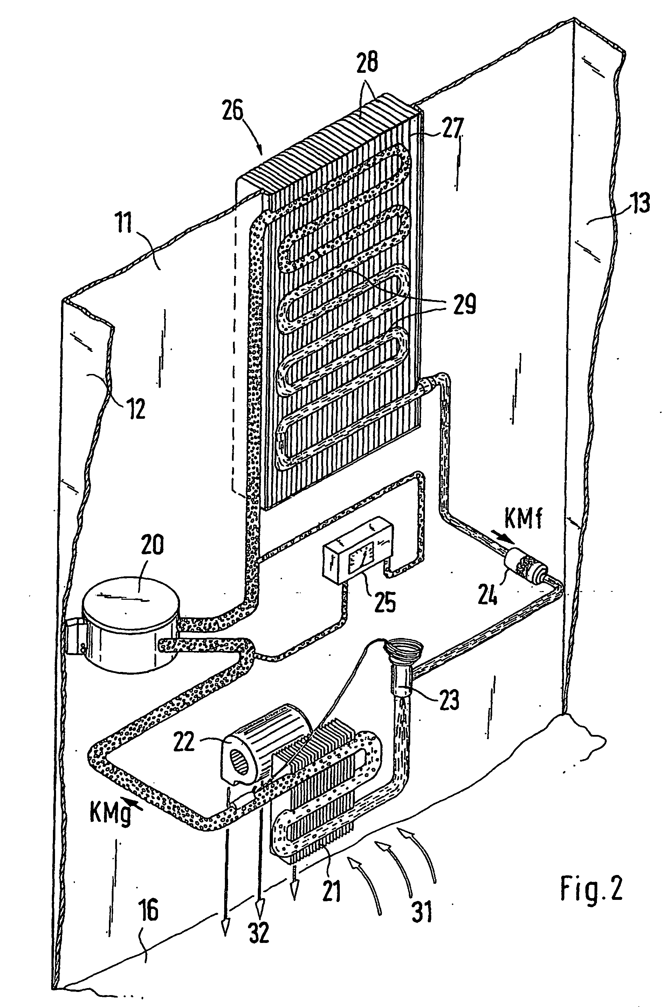

Der Kühlmittel-Kreislauf weist, wie Fig. 2 zeigt, als Hauptkomponenten einen Kompressor 20, einen Verflüssiger 26 und einen Verdampfer 21 auf. Über die Lufteintrittsöffnung 31 der Bodenwand 16, die mit einer Luftaustrittsöffnung der Schaltschrank-Deckwand fluchtet, wird unter Hilfe eines Ventilators 22 die Warmluft aus dem Schaltschrank-Innenraum gefördert und über den Verdampfer 21 geleitet. Das den Verdampfer 21 durchfließende Kältemittel KM wird gasförmig und überhitzt über den Kompressor 20 dem Verflüssiger 26 zugeführt. Dieser Verflüssiger 26 besteht aus einer Grundplatte 27, die fest und unlösbar in die Seitenwand 11 eingebaut ist und lediglich mit Kühlrippen 28 an der Außenseite des Gerätegehäuses 10 absteht, wie der Ansicht nach Fig. 1 zu entnehmen ist. Das überhitzte Kühlmittel gelangt durch Kühlmittelleitungen 29 in Form einer Kühlschlange, die in Aufnahmenuten auf der dem Kühlgeräte-Innenraum zugekehrten Seite der Grundplatte 27 eingebracht sind.

Die vorzugsweise als Kupferrohre ausgebildeten Kühlmittelleitungen 29 stehen in gutem Wärmeleitkontakt zu der aus Aluminium bestehenden Grundplatte 27. Das Kühlmittel gibt die Wärme an die Grundplatte 27 mit den angeformten Kühlrippen 28 ab, die die Wärme an die Umgebungsluft abstrahlen. Dabei kann die Wärmeabgabe durch einen den Kühlrippen 28 zugeordneten Ventilator noch gesteigert werden. Das den Verflüssiger 26 verlassende Kühlmittel KMf ist flüssig und unterkühlt und gelangt über eine Filter- und Trockeneinrichtung 24 wieder zum Verdampfer 21 zurück.

Ein Druckwächter 25 überwacht den Druckunterschied zwischen dem Kältemittel am Eingang des Kompressors 20 und am Ausgang des Verflüssigers 26. Zudem kann ein Entspannungsventil 23 zwischen der Filter- und Trockeneinrichtung 24 und dem Verdampfer 21 in den Kältemittel-Kreislauf eingeschaltet sein.

Der Verflüssiger 26 belegt mit seiner Grundplatte 27 zumindest einen Teil der Seitenwand 11, er kann jedoch je nach erforderlicher Kühlleistung auch die gesamte Seitenwand 11 bilden oder sich auf Teilbereiche mehrerer Seitenwände verteilt sein. Wichtig ist dabei nur, dass sich die Grundplatte 27 nahtlos und hermetisch dicht in das Gerätegehäuse 10 einfügen und dieses zur Umgebung hin luftdicht abschließen.

## Patentansprüche

1. Kühlgerät mit einem in einem Gerätegehäuse (10) untergebrachten Kältemittel-Krerslauf mit Kompressor (20), Verdampfer (21) und Verflüssiger (26) wobei der Kältemittel-Kreislauf einen Innenkreis und einen Außenkreis aufweist, wobei der Innenkreis über eine Seitenwand (16) des Gerätegehäuses über eine Lufteintrittsöffnung (31) und eine Luftaustrittsöffnung (32) mit einem zu kühlenden Raum, vorzugsweise einem Schaltschrankinnenraum, in Verbindung steht und dem Innenkreis der Verdampfer und dem Außenkreis der Verflüssiger des Kältemittelkreislaufes zugeordnet sind,
**dadurch gekennzeichnet,**
**dass** alle Seitenwände (11, 12, 13, 14, 15) bis auf die Seitenwand (16) mit der Lufteintrittsöffnung (31) und der Luftaustrittsöffnung (32) des Gerätegehäuses (10) vollständig geschlossen sind,
**dass** der Verflüssiger (26) als Grundplatte (27) mit eingebetteten Kühlmittelleitungen (29) ausgebildet ist, die zumindest einen Teil einer Seitenwand (11) des Gerätegehäuses (10) bildet und angeformte , an deren Außenseite abstehende Kühlrippen (28) aufweist.

2. Kühlgerät nach Anspruch 1,
**dadurch gekennzeichnet,**
**dass** die Seitenwände (11, 12, 13, 14, 15) ohne Lufteinrtittsöffnung (31) und Luftaustrittsöffnung (32) in Schutzart IP 55 oder größer das Gerätegehäuse (10) verschließen.

3. Kühlgerät nach Anspruch 1 oder 2,
**dadurch gekennzeichnet,**
**dass** die Seitenwand (16) mit der Lufteintrittsöffnung (31) und der Luftaustrittsöffnung (32) mittels Dichtungselementen mit dem zu kühlenden Raum, insbesondere dem den Schaltschrankinnenraum umschließenden Schaltschrankgehäuse (30) verbunden ist, wobei die Lufteintrittsöffnung (31) des Kühlgerätes mit der Luftaustrittsöffnung des Schaltschrankgehäuses (30) und die Luftaustrittsöffnung (32) des Kühlgerätes mit der Lufteintrittsöffnung des Schaltschrankgehäuses (30) fluchten.

4. Kühlgerät nach einem der Ansprüche 1 bis 3,
**dadurch gekennzeichnet,**
**dass** die Kühlmittelleitungen (29) als Kühlschlange in der Grundplatte (27) des Verflüssigers (26) eingebettet sind.

5. Kühlgerät nach Anspruch 4,
**dadurch gekennzeichnet,**
**dass** die Kühlmittelleitungen (29) in Aufnahmenuten der Grundplatte (27) des Verflüssigers (26) eingebettet sind, die in der dem Kühlgerät-Innenraum zugekehrten Oberfläche der Grundplatte (27) eingebracht sind.

6. Kühlgerät nach Anspruch 4 oder 5,
**dadurch gekennzeichnet,**
**dass** die Kühlmittelleitungen (29) im Bereich des oberen Teils der Grund-platte (27) eingeführt und im Bereich des unteren Teils der Grundplatte (27) herausgeführt ist.

7. Kühlgerät nach einem der Ansprüche 1 bis 6,
**dadurch gekennzeichnet,**
**dass** den Kühlrippen (28) des Verflüssigers (26) ein Außen-Ventilator und im Kühlgerät dem Verdampfer (21) ein Innen-Ventilator (21) zugeordnet sind.

8. Kühlgerät nach einem der Ansprüche 1 bis 7,
**dadurch gekennzeichnet,**
**dass** der Kühlmittelkreislauf einen Druckwächter (25) aufweist, der den Druckunterschied zwischen dem Kühlmitteleingang des vor dem Verflüssiger (26) angeordneten Kompressors (20) und dem Kühlmittelausgang des dem Kompressor (20) nachgeordneten Verflüssigers (26) überwacht.

9. Kühlgerät nach einem der Ansprüche 1 bis 8,
**dadurch gekennzeichnet,**
**dass** das Kühlmittel vor dem dem Verflüssiger (26) nachgeordneten Verdampfer (21) über eine Filter-Trockeneinrichtung (24) geleitet ist.

10. Kühlgerät nach einem der Ansprüche 1 bis 9,
**dadurch gekennzeichnet,**
**dass** der Filter-Trockeneinrichtung (24) ein Ventil (23) nachgeordnet ist.

11. Kühlgerät nach einem der Ansprüche 1 bis 10,
**dadurch gekennzeichnet,**
**dass** die Grundplatte (27) mit den angeformten Kühlrippen (28) aus Aluminium besteht und dass die Kühlmittelleitungen (29) Kupferrohre sind.

## Claims

1. Refrigerating appliance comprising a refrigerant circuit accommodated in an appliance housing (10) and having a compressor (20), evaporator (21) and condenser (26), the refrigerant circuit having an internal circuit and an external circuit, the internal circuit being connected via a side wall (16) of the appliance housing, via an air inlet port (31) and an air outlet port (32), to a space to be cooled, preferably a switch-cabinet interior, and the internal circuit of the refrigerant circuit being assigned the evaporator and its external circuit being assigned the condenser, **characterized in that** all the side walls (11, 12, 13, 14, 15), with the exception of the side wall (16) having the air inlet port (31) and the air outlet port (32) of the appliance housing (10), are closed completely, and **in that** the condenser (26) is designed as a baseplate (27) with embedded refrigerant lines (29), which forms at least part of a side wall (11) of the appliance housing (10) and which has integrally formed cooling ribs (28) projecting on its outside.

2. Refrigerating appliance according to Claim 1,
**characterized in that** the side walls (11, 12, 13, 14, 15) without an air inlet port (31) and air outlet port (32) close the appliance housing (10) to the degree of protection IP 55 or higher.

3. Refrigerating appliance according to Claim 1 or 2, **characterized in that** the side wall (16) having the air inlet port (31) and the air outlet port (32) is connected by means of sealing elements to the space to be cooled, in particular the switch-cabinet housing (30) surrounding the switch-cabinet interior, the air inlet port (31) of the refrigerating appliance being in alignment with the air outlet port of the switch-cabinet housing (30), and the air outlet port (32) of the refrigerating appliance being in alignment with the air inlet port of the switch-cabinet housing (30).

4. Refrigerating appliance according to one of Claims 1 to 3, **characterized in that** the refrigerant lines (29) are embedded as a refrigerating coil in the baseplate (27) of the condenser (26).

5. Refrigerating appliance according to Claim 4, **characterized in that** the refrigerant lines (29) are embedded in reception grooves of the baseplate (27) of the condenser (26) which are introduced **in that** surface of the baseplate (27) which faces the interior of the refrigerating appliance.

6. Refrigerating appliance according to Claim 4 or 5, **characterized in that** the refrigerant lines (29) are led in in the region of the upper part of the baseplate (27) and are led out in the region of the lower part of the baseplate (27).

7. Refrigerating appliance according to one of Claims 1 to 6, **characterized in that** the cooling ribs (28) of the condenser (26) are assigned an external fan and, in the refrigerating appliance, the evaporator (21) is assigned an internal fan (21).

8. Refrigerating appliance according to one of Claims 1 to 7, **characterized in that** the refrigerant circuit has a pressure monitor (25) which monitors the pressure difference between the refrigerant entry to the compressor (20) arranged upstream of the condenser (26) and the refrigerant exit of the condenser (26) arranged downstream of the compressor (20).

9. Refrigerating appliance according to one of Claims 1 to 8, **characterized in that** the refrigerant is conducted, upstream of the evaporator (21) arranged downstream of the condenser (26), via a filter drying device (24).

10. Refrigerating appliance according to one of Claims 1 to 9, **characterized in that** a valve (23) is arranged downstream of the filter drying device (24).

11. Refrigerating appliance according to one of Claims 1 to 10, **characterized in that** the baseplate (27) together with the integrally formed cooling ribs (28) consists of aluminium, and **in that** the refrigerant lines (29) are copper pipes.

## Revendications

1. Appareil réfrigérant avec un circuit d'agent réfrigérant placé dans un boîtier d'appareil (10) avec un compresseur (20), un évaporateur (21) et un condenseur (26), le circuit d'agent réfrigérant présentant un circuit intérieur et un circuit extérieur, le circuit intérieur étant en liaison par le biais d'une paroi latérale (16) du boîtier d'appareil, par l'intermédiaire d'une ouverture d'entrée d'air (31) et d'une ouverture de sortie d'air (32), avec un espace à refroidir, de préférence un espace interne d'armoire de distribution, et l'évaporateur étant associé au circuit intérieur et le condenseur du circuit d'agent réfrigérant étant associé au circuit extérieur,
**caractérisé en ce que**
toutes les parois latérales (11, 12, 13, 14, 15) à l'exception de la paroi latérale (16) avec l'ouverture d'entrée d'air (31) et l'ouverture de sortie d'air (32) du boîtier d'appareil (10) sont entièrement fermées,
**en ce que** le condenseur (26) est réalisé sous forme de plaque de base (27) avec des conduites d'agent réfrigérant encastrées (29), laquelle forme au moins une partie d'une paroi latérale (11) du boîtier d'appareil (10) et présente des nervures de refroidissement (28) moulées, saillant au niveau de son côté extérieur.

2. Appareil réfrigérant selon la revendication 1,
**caractérisé en ce que**
les parois latérales (11, 12, 13, 14, 15) sans ouverture d'entrée d'air (31) et sans ouverture de sortie d'air (32) ferment le boîtier d'appareil (10) avec une protection IP 55 ou supérieure.

3. Appareil réfrigérant selon la revendication 1 ou 2,
**caractérisé en ce que**
la paroi latérale (16) avec l'ouverture d'entrée d'air (31) et l'ouverture de sortie d'air (32) est connectée au moyen d'éléments d'étanchéité à l'espace à refroidir, notamment au boîtier d'armoire de distribution (30) entourant l'espace interne de l'armoire de distribution, l'ouverture d'entrée d'air (31) de l'appareil réfrigérant étant en affleurement avec l'ouverture de sortie d'air du boîtier de l'armoire de distribution (30) et l'ouverture de sortie d'air (32) de l'appareil réfrigérant étant en affleurement avec l'ouverture d'entrée d'air du boîtier de l'armoire de distribution (30).

4. Appareil réfrigérant selon l'une quelconque des revendications 1 à 3,
**caractérisé en ce que**
les conduites d'agent réfrigérant (29) sont encastrées dans la plaque de base (27) du condenseur (26) sous forme de serpentin de condensation.

5. Appareil réfrigérant selon la revendication 4,
**caractérisé en ce que**
les conduites d'agent réfrigérant (29) sont encastrées dans des rainures de réception de la plaque de base (27) du condenseur (26), qui sont pratiquées dans la surface de la plaque de base (27) tournée vers l'espace interne de l'appareil réfrigérant.

6. Appareil réfrigérant selon la revendication 4 ou 5,
**caractérisé en ce que**
les conduites d'agent réfrigérant (29) sont introduites dans la région de la partie supérieure de la plaque de base (27) et sont ressorties dans la région de la partie inférieure de la plaque de base (27).

7. Appareil réfrigérant selon l'une quelconque des revendications 1 à 6,
**caractérisé en ce qu'**un
ventilateur extérieur est associé aux nervures de refroidissement (28) du condenseur (26) et un ventilateur intérieur est associé à l'évaporateur (21) dans l'appareil réfrigérant.

8. Appareil réfrigérant selon l'une quelconque des revendications 1 à 7,
**caractérisé en ce que**
le circuit d'agent réfrigérant présente un manostat (25) qui contrôle la différence de pression entré l'entrée d'agent réfrigérant du compresseur (20) disposé avant le condenseur (26) et la sortie d'agent réfrigérant du condenseur (26) placé après le compresseur (20).

9. Appareil réfrigérant selon l'une quelconque des revendications 1 à 8,
**caractérisé en ce que**
l'agent réfrigérant est guidé avant l'évaporateur (21) placé après le condenseur (26) par le biais d'un dispositif de séchage à filtre (24).

10. Appareil réfrigérant selon l'une quelconque des revendications 1 à 9,
**caractérisé en ce qu'**une, soupape (23) est placée après le dispositif de séchage à filtre (24) .

11. Appareil réfrigérant selon l'une quelconque des revendications 1 à 10,
**caractérisé en ce que**
la plaque de base (27) avec les nervures de refroidissement moulées (28) se compose d'aluminium et **en ce que** les conduites d'agent réfrigérant (29) sont des tubes en cuivre.
